(19) Europäisches Patentamt
European Patent Office
Office européen des brevets

(11) Publication number: **0 141 561 B1**

# (12) EUROPEAN PATENT SPECIFICATION

(45) Date of publication of patent specification: **26.07.89**

(21) Application number: **84307026.9**

(22) Date of filing: **15.10.84**

(51) Int. Cl.[4]: **C 30 B 29/40,** C 30 B 25/02, C 23 C 16/30, H 01 L 21/205, H 01 L 29/207

## (54) A process for producing devices having semi-insulating indium phosphide based compositions.

(30) Priority: **21.10.83 US 544215**
**26.04.84 US 604370**

(43) Date of publication of application:
**15.05.85 Bulletin 85/20**

(45) Publication of the grant of the patent:
**26.07.89 Bulletin 89/30**

(84) Designated Contracting States:
**DE FR GB NL**

(56) References cited:
**FR-A-2 397 876**
**US-A-3 164 621**
**US-A-3 188 335**
**US-A-3 421 952**
**US-A-4 193 835**
**US-A-4 314 873**

**PATENTS ABSTRACTS OF JAPAN, vol. 2, no. 32, 28th February 1978, p. 12343 E 77**

**JOURNAL OF THE ELECTROCHEMICAL SOCIETY, vol. 128, no. 8, August 1981, pages 1814-1817, Manchester, New Hampshire, US;**

**J.D. OBERSTAR et al.: "Iron and chromium redistribution in semi-insulating InP"**

(73) Proprietor: **AMERICAN TELEPHONE AND TELEGRAPH COMPANY**
**550 Madison Avenue**
**New York, NY 10022 (US)**

(72) Inventor: **Johnston, Wilbur Dexter, Jr.**
**30 Oak Knoll Road**
**Mendham New Jersey 07945 (US)**
Inventor: **Long, Judith Ann**
**170 Myrtle Avenue**
**Millburn New Jersey 07041 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

(56) References cited:
**JOURNAL OF APPLIED PHYSICS, vol. 52, no. 11, November 1981, pages 6729-6734, American Institute of Physics, US; J.J. YANG et al.: "Electrical properties of epitaxial indium phosphide films grown by metalorganic chemical vapor deposition"**

**EXTENDED ABSTRACTS, vol. 83-1, May 1983, page 530, abstract no. 339, Pennington, N.J., US; C.C. HSU et al.: "OMVPE growth of GaP InP and GaInP"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 141 561 B1**

**Description**

This invention relates to a process for producing devices having semi-insulating indium phosphide based materials.

The III—V semiconductor materials such as gallium arsenide, indium phosphide, gallium indium phosphide, indium phosphide arsenide, and gallium indium arsenide phosphide are being utilized and/or have been investigated for various devices. In general, these devices such as laser devices or Field Effect Transistors (FETs) are formed by a series of deposition processes resulting in a layered structure formed on an essentially single crystal substrate. Generally, a region is introduced within the structure to confine or restrict the flow of current to desired device paths, i.e., to device active regions. Various expedients such as a patterned oxide layer or a reverse biased p-n junction are employed for this isolation. However, the oxide layer does not permit epitaxial overgrowth. The p-n junction expedient which does allow overgrowth, nevertheless, yields a resistivity that is highly temperature dependent. Thus, research has been stimulated towards the development of a semi-insulating single crystalline region within the structure since the resistivity of such regions is not strongly temperature dependent and since subsequent overgrowth is possible. Semi-insulating material is generally formed by suitably doping the desired III—V semiconductor material. For example, in the formation of gallium arsenide based layers for FET applications, one method of forming a semi-insulating gallium arsenide region involves introducing chromium as a dopant. The chromium doped gallium arsenide layer is generally fabricated by chemical vapor deposition (CVD) growth in a gas transport system. In a typical procedure, a gallium arsenide wafer is heated and a deposition gas is prepared that includes gallium chloride and arsenic compounds such as $As_2$ and/or $As_4$. These materials are transported in a hydrogen stream or in an inert gas stream, e.g., a helium stream. Upon contacting the heated substrate, gallium arsenide is deposited with the release of a chloride containing gas. The reactions involved are, thus, shown in the following equations

$$GaCl+As_2 \xrightarrow{H_2} GaAs+HCl$$

or

$$GaCl+As_2 \xrightarrow{He} GaAs+Cl_2$$

An appropriate dopant precursor is introduced into the deposition gas stream to produce the desired semi-insulating properties. For example, a chromyl chloride dopant precursor as described in U.S. Patent 4,204,893 issued May 27, 1980 is utilized for producing semi-insulating gallium arsenide. However, chromium compounds are not the only dopant precursors that have been suggested for doping gallium arsenide. Other dopant precursors such as iron pentacarbonyl for gallium arsenide doping have been disclosed. (See U.S. Patent 3,492,175 issued January 27, 1970).

Indium phosphide has also been formed by a CVD process. In particular, a gas stream including volatile indium halide entities such as InCl, $InCl_2$, and $In_2Cl_3$ and phosphorus containing entities such as $PH_3$, $P_2$ and $P_4$ are utilized in a hydrogen atmosphere to form indium phosphide and HCl as shown in the following equation.

$$H_2+\left.\begin{matrix} InCl \\ InCl_2 \\ In_2Cl_3 \end{matrix}\right] + \left.\begin{matrix} PH_3 \\ P_2 \\ P_4 \end{matrix}\right] \rightarrow InP+HCl$$

Unlike gallium arsenide deposition, an inert gas carrier system such as a helium carrier system does not result in the deposition of indium phosphide. Since a reducing carrier e.g., a hydrogen carrier, is necessary in conventional CVD of indium phosphide, the dopant precursor employed has been limited to those that do not undergo reduction to produce elemental metals of low volatility. (Premature reduction to a non-vonatile elemental metal by interaction with the carrier gas does not result in dopant incorporation, but instead induces essentially complete depletion of the dopant by formation of the metal on the reactor walls or in the gas phase). Therefore, only chromium-based dopant precursors have been utilized to form semi-insulating indium phosphide layers. (See Alferov et al, *Soviet Technical Physics Letters, 8(6),* 296 (1982) and L. A. Ivanyutin and I. N. Tsypleiko, *Elektronnaya Tekhnika,* No. 6, 155, 20 (1981)). However, as disclosed by Alferov et al *supra*, chromium-doped indium phosphide epitaxial layers having resistivities of only approximately $5\times10^3$ ohm-cm have been produced. This resistivity level is marginally acceptable for discrete devices such as lasers. However, for arrays of lasers or for integrated circuits, it is highly desirable to have a material with a significantly higher resistivity—a resistivity greater than $10^6$ ohm-cm—to avoid, for example, electrical leakage and undesirable cross coupling of elements in an integrated circuit. Thus, production of suitable resistivities for indium phosphide layers has not been attained with conventional systems despite the success of these systems for gallium arsenide.

The preamble of claims 1 and 2 are based on US—A—4193835 which describes a method of growing a semiconductor layer with a metal dopant by vapour phase epitaxy using dicyclopentadienyl metal as the dopant source. Details are given of the growth of Fe-doped GaAs using $Fe(C_2H_5)_2$ as the source of iron. It is stated that the method may also be employed in doping Fe, Cr or Ni into various semiconductors consisting of elements from groups III and V, groups II and VI and group IV. One of the claims lists GaAs, Si, CdS, InP and PbSe as suitable semiconductors.

In Journal of the Electrochemical Society, Vol. 128, No. 8, August 1981, pages 1814—1817 some

experiments are described on semi-insulating Fe-doped InP. This material is produced as a bulk crystal by the liquid-encapsulation Czochralski method. The problem of forming a semi-insulating layer is not addressed.

With the invention as claimed iron is used as a dopant and higher resistivities are obtainable.

Indium phosphide having a resistivity up to $1 \times 10^9$ ohm-cm has been produced utilizing a metal organic chemical vapor deposition (MOCVD) procedure in conjunction with an iron pentacarbonyl or ferrocene based dopant precursor. The use of an iron pentacarbonyl or ferrocene based dopant precursor in the formation of indium phosphide through MOCVD results in device quality semi-insulating layers and avoids significant loss of dopant through premature deposition of elemental iron. For example, excellent results are achieved by employing these dopant precursors in conjunction with indium-organic materials such as alkyl indium-alkyl phosphine adducts, e.g., trimethyl indium-trimethyl phosphine adduct, together with additional phosphine. Once the device semi-insulating layers are formed, the device active regions are produced by conventional techniques.

Some embodiments of the invention will now be described by way of example with reference to the accompanying drawing which is illustrative of an apparatus useful practicing the invention.

The embodiments to be described involve the use of either a ferrocene or iron pentacarbonyl based dopant precursor (or a combination of such precursors) in conjunction with an indium-organic material to produce growth of a semi-insulating, i.e., resistivity of at least $10^6$ ohm-cm, indium phosphide-based material and ultimately to produce a device. The metal organic deposition of indium phosphide has been extensively described in articles such as "GaAs and Related Compounds", J. P. Duchemin, M. Bonnet, G. Beuchet, and F. Koelsch, *Institute of Physics Conference Seriès 45,* 1979, page 45; "International Meeting on the Relationship Between Epitaxial Growth Conditions and the Properties of Semiconductor Epitaxial Layers", A. K. Chatterjee, M. M. Faktor, R. H. Moss, and E. A. D. White, Perpignan, France, 1982. The particular indium-organic material utilized for deposition of the indium phosphide-based material in conjunction with a ferrocene or iron pentacarbonyl based dopant precursor is not critical. Typically, indium alkyls such as trimethyl indium and triethyl indium where the alkyl preferably has 1 to 5 carbon atoms in conjunction with a source of phosphorus, e.g., phosphine, produce indium phosphide of satisfactory quality.

Although it is possible to introduce the alkyl indium materials separately into the gas deposition stream, there are several advantages in first forming an adduct between the indium-organic and an alkyl phosphine such as trimethyl phosphine and/or triethyl phosphine, where the alkyl of the phosphine preferably has 1 to 5 carbon atoms. Solid materials such as trimethyl indium are brought into the gas state through sublimation utilizing a gas stream such as a hydrogen gas stream. Although this introduction method for solid alkyl indium compounds is possible, the maintenance of the vapor concentration in the gas flow at essentially constant levels is difficult. Liquid materials, on the other hand, such as triethyl indium, are introduced by passing a gas flow through a bubbler. However, these materials generally have low vapor pressures, and thus adequate concentration is difficult to attain. Raising the bubbler temperature to avoid this difficulty results in disadvantageous decompositions, while increasing the carrier flow results in incomplete saturation of the gas. In contrast, the adduct of the trialkyl indium compound and the trialkyl phosphine is a low melt point solid that is employable in a stable liquid form at moderately elevated temperatures and that is easily introduced into a gas stream by bubbling a gas such as hydrogen through it. Additionally, the trialkyl indium compounds alone are vigorously pyrophoric while the adduct is not pyrophoric. The adduct is also useful, but not essential as an expedient, for preventing undesirable polymerization of the organo-indium compound.

In a preferred embodiment, the adduct is introduced into the gas stream by flowing a gas, e.g., hydrogen or an inert gas such as nitrogen or helium, through a bubble containing it. It is desirable that the gas be relatively pure so that impurities are not introduced into the deposited indium phosphide. For example, it is advantageous, although not essential, to employ high purity hydrogen that is further purified by palladium diffusion. Sufficient carrier gas, e.g., hydrogen or an inert gas such as nitrogen or helium, is then flowed through the bubbler to produce a saturated combination of carrier gas and gas-based adduct. (The flow need not necessarily be saturated but much greater control is achieved by utilizing a saturated gas flow. Poor control is, however, particularly undesirable for growing ternary and quaternary indium phosphide-based materials). Typically, gas flows in the range of 50 to 200 sccm are utilized with a bubbler heated to a temperature in the range 60 to 100 degrees C to produce a saturated gas flow. A controlled sample is employed to determine suitable conditions for producing saturation for a given adduct.

A source of phosphorus, e.g., phosphine, is also introduced into the gas flow. Generally, it is desirable to have a molar excess of phosphorus source, e.g., phosphine, to organic-indium compound of at least 50:1, preferably at least 75:1. Ratios less than 50:1 generally allow phosphorus escape from the already deposited indium phosphide layer. This escape yields a generally degraded morphology for the deposited indium phosphide. Typically, ratios greater than 100:1, although not precluded, are also not desirable since they are uneconomic.

The dopant precursor, a ferrocene and/or an iron pentacarbonyl based composition, is introduced to yield a mole ratio of iron to indium in the gas stream in the range $1.2 \times 10^{-4}$ to $1 \times 10^{-5}$. Molar ratios significantly higher than $1.2 \times 10^{-4}$ lead to inclusion of a second composition phase in the deposition while molar ratios less than $1 \times 10^{-5}$ lead to insufficient resistivities in deposited indium phosphide-based layers having a background carrier concentration of approximately $2 \times 10^{15}$ $cm^{-3}$. (Indium phosphide having a lower background concentration requires less dopant compensation. Thus, lower ratios for such materials are not precluded).

A wide variety of iron pentacarbonyl based compositions is employable. For example, an iron pentacarbonyl based composition, such as butadiene iron tricarbonyl, cyclooctatetraene iron tricarbonyl 1,3-pentadiene iron tricarbonyl, iron pentacarbonyl, cyclohexadiene iron tricarbonyl, cycloheptadiene iron tricarbonyl, cycloheptatriene iron tricarbonyl, cyclopentadienyl iron dicarbonyl dimer, and methylcyclopentadienyl iron dicarbonyl dimer are employable. Similarly, a wide variety of ferrocenes is also employable. For example, compounds such as ferrocene, dimethyl ferrocene, vinyl ferrocene, and butyl ferrocene are also useful. Conventional techniques are utilized to introduce the dopant precursor. For example, in the case of ferrocene, which is a solid at room temperature, a gas flow such as a hydrogen gas flow is passed over the ferrocene to induce sublimation. Typical gas flows in the range 5 to 20 sccm passed over the ferrocene at a temperature in the range 0 to 25 degrees C produce the desired ratio of indium to iron in the gas stream. For precursors such as iron pentacarbonyl, an effusion source is preferably utilized. In this embodiment, a gas flow, such as a hydrogen gas flow, is first introduced into a gas flow control means such as an electronic mass flow controller or needle valve that is adjusted to yield the desired iron-to-indium ratio and then passed over the effusion source containing the precursor, e.g., iron pentacarbonyl.

Although for pedagogic purposes the deposition has been described in terms of InP, the invention also extends to indium phosphide-based materials in general, i.e., indium phosphide as well as ternary and quaternary systems that include both indium and phosphorus such as indium gallium phosphide, indium phosphide arsenide, indium gallium aluminum phosphide, and indium gallium arsenide phosphide. In these systems, either arsenic and/or gallium and/or aluminum is introduced into the gas stream by expedients such as, respectively, an admixture of $AsH_3$ and use of a bubbler containing alkyl gallium and/or alkyl aluminum compounds such as described in *Journal of Crystal Growth, 55,* 64 (1981), by J. P. Duchemin et al. Formation of device active regions and, indeed completion of the device such as an array of lasers and/or optoelectronic integrated circuit, are then accomplished by conventional techniques.

The following examples are illustrative of the invention.

Example 1

A polished indium phosphide substrate, 5, measuring 1.91×2.54 cm (3/4×1 inch) and 0.0254 cm (0.010 inch) in thickness was cleaned in methanol and placed on a silicon carbide coated graphite susceptor, 10. This susceptor, together with the substrate, was positioned on the sample holder, 15, through loading port, 20, of a quartz reactor tube measuring 70 mm inside diameter. The susceptor was then moved to the growth position using rod, 25 and magnet, 35. A hydrogen flow was then established over the substrate at a rate of 5.5 l/min.

A trimethyl indium/trimethyl phosphine adduct was prepared by mixing the two components in a mole ratio of 1 part trimethyl indium to 1.2 parts trimethyl phosphine. This adduct was purified by sublimation to yield a 1:1 adduct and then placed in a bubbler that was heated to a temperature of 70 degrees C. Approximately 25 grams of ferrocene were placed in a sublimer that was held at 10 degrees C. A 140 sccm flow of hydrogen was passed through the adduct bubbler, and a 20 sccm $H_2$ flow was passed through the sublimer. Then the combined flow as directed through a line that bypassed the reactor. The susceptor was heated by subjecting it to an r.f. power sufficient to raise the substrate temperature to 700 degrees C as measured by thermocouple, 30. During initial heating when the susceptor reached a temperature of 300 degrees C, a flow of 1000 sccms of a 5 percent by volume mixture of $PH_3$ in $H_2$ was substituted for an equivalent flow of the original hydrogen flow through the reactor. (This initial flow was employed to prevent substrate decomposition). The r.f. heating was continued until the substrate reached a temperature of 700 degrees C. The r.f. heating was then adjusted to maintain the substrate at this temperature. The combined hydrogen flows were transferred from the bypass line and combined with the $PH_3$ $H_2$ flow. (These conditions produced an InP growth rate of approximately 2.5 µm per hour).

Growth was continued for 90 minutes until the desired InP layer thickness (3.5 µm) was achieved. Flow through the bubbler and sublimer was then terminated. The substrate was maintained at 700 degrees C for 2 minutes after flow termination to ensure that all the metal-organic vapor has been removed from the reactor. The r.f. heating was then also terminated and the substrate was allowed to cool. When the substrate temperature reached 300 degrees C, the $PH_3$ flow was eliminated. A hydrogen flow, however, was continued while the substrate was allowed to cool to room temperature. The resulting InP layer had a resistivity of approximately $10^8$ ohm-cm.

Example 2

The procedure of example 1 was employed, except the dopant precursor was iron pentacarbonyl rather than ferrocene. This precursor was introduced utilizing an effusion source at −17 degrees C with a 20 sccm $H_2$ flow. The resulting layer had a resistivity of approximately $10^8$ ohm-cm.

A polished indium phosphide substrate measuring 1.91×2.54 cm (3/4×1 inch) and 0.0254 cm (0.10 inch) in thickness was cleaned in methanol and placed on a silicon carbide coated graphite susceptor, 10. This susceptor, together with the substrate, was positioned on the sample holder, 15, through loading port, 20 of a quartz reactor tube measuring 70 mm inside diameter. The susceptor was then moved to the growth position using rod, 25, and magnet, 35. A hydrogen flow as then established over the substrate at a rate of 6 l/min.

A trimethyl indium/trimethyl phosphine adduct was prepared by mixing the two components in a mole ratio of 1 part trimethyl indium to 1.2 parts trimethyl phosphine. This adduct was purified by sublimation to yield a 1:1 adduct and then placed in a bubbler that was heated to a temperature of 70 degrees C. Approximately 10 grams of butadiene iron tricarbonyl were placed in a sublimer that was held at −6 degrees C. A 140 sccm flow of hydrogen was passed through the adduct bubbler, and a 5 sccm $H_2$ flow was passed through the sublimer. Then the combined flow was directed through a line that bypassed the reactor. The susceptor was heated by subjecting it to an r.f. power sufficient to raise the substrate temperature to 650 degrees C as measured by thermocouple 30. During initial heating when the susceptor reached a temperature of 300 degrees C, a flow of 750 sccm of a 5 percent by volume mixture of $PH_3$ in $H_2$ was substituted for an equivalent flow of the original hydrogen flow through the reactor. (This initial flow was employed to prevent substrate decomposition). The r.f. heating was continued until the substrate reached a temperature of 650 degrees C. The r.f. heating was then adjusted to maintain the substrate at this temperature. The combined hydrogen flows were transferred from the bypass line and combined with the $PH_3/H_2$ flow. (These conditions produced an InP growth rate of approximately of 4 µm per hour).

Growth was continued for 60 minutes until the desired InP layer thickness (4 µm) was achieved. Flow through the bubbler and sublimer was then terminated. The substrate was maintained at 650 degrees C for 2 minutes after flow termination to ensure that all the metal-organic vapor had been removed from reactor. The r.f. heating was then also terminated and the substrate was allowed to cool. When the substrate temperature reached 300 degrees C, the $PH_3$ flow was eliminated. A hydrogen flow, however, was continued while the substrate was allowed to cool to room temperature. The resulting InP layer had a resistivity of approximately $10^8$ ohm-cm.

Example 4

The procedure of Example 3 was followed except cyclooctatetraene iron tricarbonyl was employed rather than butadiene iron tricarbonyl. Additionally, the temperature of the cyclooctatetraene iron tricarbonyl sublimer was 9 degrees C, and the hydrogen flow through the sublimer was 20 sccm. The resistivity of the resulting doped indium phosphide was $6\times10^7$ ohm-cm.

**Claims**

1. A process for producing a device including forming a layer of semi-insulating metal doped indium-phosphide-based material by contacting a substrate with a deposition gas stream including a dopant precursor comprising a metallocene based composition characterised in that the metal is iron, the metallocene is ferrocene and the deposition gas stream is produced by combining entities including an organo-indium compound and a source of phosphorus wherein the mole ratio of iron to indium in said gas stream is less than $1.2\times10^{-4}$ but sufficiently high that the said region has a resistivity of at least $10^6$ ohm-cm and wherein said source of phosphorus is in molar excess to said organo-indium compound.

2. A process for producing a device including forming a layer of semi-insulating metal-doped indium-phosphide-based material by contacting a substrate with a deposition gas stream including a dopant precursor characterised in that the metal is iron, the dopant precursor comprises at least one iron pentacarbonyl based composition and the deposition gas stream is produced by combining entities including an organo-indium compound and a source of phosphorus wherein the molar ratio of iron to indium in said gas stream is less than $1.2\times10^{-4}$ but sufficiently high that the said region has a resistivity of at least $10^6$ ohm-cm and wherein said source of phosphorus is in molar excess to said organo-indium compound.

3. A process as claimed in claim 2 wherein the iron pentacarbonyl based composition comprises butadiene iron tricarbonyl, cyclooctatetraene iron tricarbonyl, 1,3 - pentadiene iron tricarbonyl, cyclohexadiene iron tricarbonyl, cycloheptadiene iron tricarbonyl, cycloheptatriene iron tricarbonyl, cyclopentadienyl iron dicarbonyl dimer, methylcyclopentadienyl iron dicarbonyl dimer or iron pentacarbonyl.

4. A process as claimed in claim 1 wherein the ferrocene based composition comprises ferrocene, dimethyl ferrocene, vinyl ferrocene or butyl ferrocene.

5. A process as claimed in any of the preceding claims wherein the source of phosphorus comprises phosphine.

6. A process as claimed in any of the preceding claims wherein the organo-indium compound is indium trialkyl.

7. A process as claimed in claim 6 wherein the indium trialkyl is trimethyl indium.

8. A process as claimed in any of the preceding claims wherein the indium phosphide-based material is indium phosphide.

9. A process as claimed in any of the preceding

claims wherein the device comprises a laser or an integrated optoelectronic circuit.

**Patentansprüche**

1. Verfahren zum Herstellen eines Bauelementes, umfassend

—Ausbilden einer Schicht aus einem metalldotierten halbisolierenden Material auf Indiumphosphid - Basis durch Kontaktieren eines Substrates mit einem Niederschlags - Gasstrom, der einen eine Zusammensetzung auf Metallocen - Basis umfassenden Dotierstoffvorläufer aufweist, dadurch gekennzeichnet, daß

—das Metall Eisen ist,

—das Metallocen Ferrocen ist und

—der Niederschlags-Gasstrom erzeugt wird durch Kombinieren von Komponenten einschließlich einer Organoindiumverbindung und einer Quelle für Phosphor,

—wobei das Molenverhältnis von Eisen zu Indium in dem Gasstrom kleiner als $1{,}2\times10^{-4}$ aber ausreichend hoch ist derart, daß die Schicht einen spezifischen Widerstand von wenigstens $10^6$ Ohm-cm hat, und

—wobei die Quelle für Phosphor in molarem Überschuß gegenüber der Organoindiumverbindung vorliegt.

2. Verfahren zum Herstellen eines Bauelementes, umfassend die Ausbildung einer Schicht aus einem halbisolierenden, metalldotierten Material auf Indiumphosphidbasis durch Kontaktieren eines Substrates mit einem Niederschlagsgasstrom, der einen Dotierstoffvorläufer enthält, dadurch gekennzeichnet, daß

—das Metall Eisen ist,

—der Dotierstoffvorläufer wenigstens eine Eisenverbindung auf Pentacarbonylbasis umfaßt und

—der Niederschlagsgasstrom erzeugt wird durch Kombineren von Komponenten einschließlich einer Organoindiumverbindung und einer Quelle für Phosphor,

—wobei das Molenverhältnis von Eisen zu Indium in dem Gasstrom kleiner als $1{,}2\times10^{-4}$ aber ausreichend hoch ist derart, daß die Schicht einen spezifischen Widerstand von wenigstens $10^6$ Ohm-cm hat, und

—wobei die Quelle für Phosphor in molarem Überschuß gegenüber der Organoindiumverbindung vorliegt.

3. Verfahren wie in Anspruch 2 beansprucht, wobei die Eisenzusammensetzung auf Carbonylbasis Butadieneisentricarbonyl, Cyclooctatetraeneisentricarbonyl, 1,3 - Pentadieneisentricarbonyl, Cyclohexadieneisentricarbonyl, Cycloheptadieneisentricarbonyl, Cycloheptatrieneisentricarbonyl, Cyclopentadienyleisendicarbonyldimer, Methylcyclopentadienyleisendicarbonyldimer oder Eisenpentacarbonyl umfaßt.

4. Verfahren wie in Anspruch 1 beansprucht, wobei die Zusammensetzung auf Ferrocenbasis Ferrocen, Dimethylferrocen, Vinylferrocen oder Butylferrocen umfaßt.

5. Verfahren wie in einem der vorstehenden Ansprüche beansprucht, wobei die Quelle für Phosphor Phosphin umfaßt.

6. Verfahren wie in einem der vorstehenden Ansprüche beansprucht, wobei die Organoindiumverbindung Indiumtrialkyl ist.

7. Verfahren wie in Anspruch 6 beansprucht, wobei das Indiumtrialkyl Trimethylindium ist.

8. Verfahren wie in einem der vorstehenden Ansprüche beansprucht, wobei das Material auf Indiumphosphidbasis Indiumphosphid ist.

9. Verfahren wie in einem der vorstehenden Ansprüche beansprucht, wobei das Bauelement einen Laser oder eine integrierte optoelektronische Schaltung umfaßt.

**Revendications**

1. Un procédé de fabrication d'un dispositif comprenant la formation d'une couche de matériau semi-isolant à base de phosphure d'indium dopé par un métal, par la mise en contact d'un substrat avec un écoulement de gaz de dépôt contenant un précurseur de dopant comprenant une composition à base de métallocène, caractérisé en ce que le métal est du fer, le métallocène est du ferrocène et l'écoulement de gaz de dépôt est produit en combinant des composants contenant un composé organique de l'indium et une source de phosphore, dans les conditions dans lesquelles le rapport molaire fer-indium dans l'écoulement de gaz est inférieur à $1{,}2\times10^{-4}$ mais est suffisamment élevé pour que la couche ait une résistivité d'au moins $10^6$ Ω-cm, et dans lesquelles la source de phosphore présente en excès molaire par rapport au composé organique de l'indium.

2. Un procédé de fabrication d'un dispositif comprenant la formation d'une couche d'un matériau semi-isolant à base de phosphure d'indium dopé par un métal, par la mise en contact d'un substrat avec un écoulement de gaz de dépôt contenant un précurseur de dopant, caractérisé en ce que le métal est du fer, le précurseur de dopant comprend au moins une composition à base de fer pentacarbonyle, et l'écoulement de gaz de dépôt est produit en combinant des composants comprenant un composé organique de l'indium et une source de phosphore, dans des conditions dans lesquelles le rapport molaire fer/indium dans cet écoulement de gaz est inférieur à $1{,}2\times10^{-4}$ mais est suffisamment élevé pour que la couche ait une résistivité d'au moins $10^6$ Ω-cm, et dans lesquelles la source de phosphore présente un excès molaire par rapport au composé organique de l'indium.

3. Un procédé selon la revendication 2, dans lequel la composition à base de fer pentacarbonyle comprend du butadiène fer tricarbonyle, du cyclooctatétraène fer tricarbonyle, du 1,3 - pentadiène fer tricarbonyle, du cyclohexadiène fer tricarbonyle, du cycloheptadiène fer tricarbonyle, du cycloheptatriène fer tricarbonyle, du cyclopentadiènyl fer dicarbonyle

dimère, du méthylcyclopentadiènyl fer dicarbonyle dimère ou du fer pentacarbonyle.

4. Un procédé selon la revendication 1, dans lequel la composition à base de ferrocène comprend du ferrocène, du diméthylferrocène, du vinylferrocène ou du butylferrocène.

5. Un procédé selon l'une quelconque des revendications précédentes, dans lequel la source de phosphore consiste en phosphine.

6. Un procédé selon l'une quelconque des revendications précédentes, dans lequel le composé organique de l'indium est de l'indium trialkyle.

7. Un procédé selon la revendication 6, dans lequel l'indium trialkyle est du triméthylindium.

8. Un procédé selon l'une quelconque des revendications précédentes, dans lequel le matériau à base de phosphure d'indium est du phosphure d'indium.

9. Un procédé selon l'une quelconque des revendications précédentes dans lequel le dispositif consiste en un laser ou un circuit intégré optoélectronique.

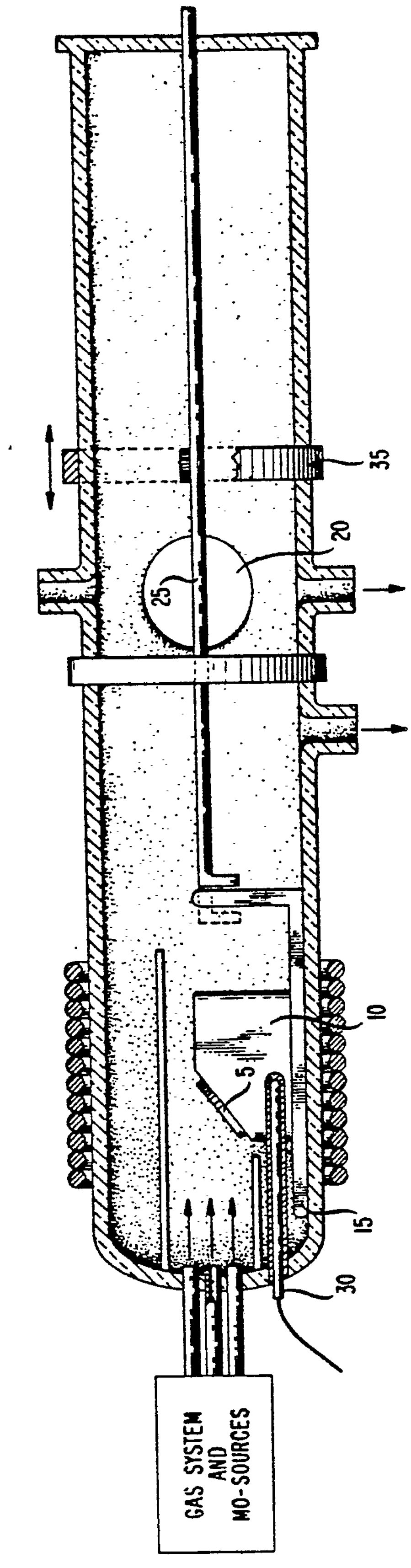
35
20
25
10
5
15
30
GAS SYSTEM
AND
MO-SOURCES